Europäisches Patentamt

European Patent Office

Office européen des brevets

(19)

(11) EP 1 528 779 A1

(12) **EUROPEAN PATENT APPLICATION**

(43) Date of publication:
**04.05.2005 Bulletin 2005/18**

(51) Int Cl.7: **H04M 11/06**, H03F 1/32,
H03C 3/09, H04L 27/12,
H04B 1/04

(21) Application number: **03078399.7**

(22) Date of filing: **29.10.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicant: **Nuovotel Properties A.V.V.**<br>**Curacao, Netherlands Antilles (AN)**<br><br>(72) Inventors:<br>• **Letounov, Leonid**<br>  **246012 Gomel (BY)** | • **Sharayeuski, Vladimir**<br>  **246020 Gomel (BY)**<br>• **Hryhoryeu, Aliaksandr**<br>  **246012 Gomel (BY)**<br><br>(74) Representative: **Hylarides, Paul Jacques et al**<br>  **Arnold & Siedsma,**<br>  **Sweelinckplein 1**<br>  **2517 GK The Hague (NL)** |

(54) **System and method for frequency modulation in a modem**

(57)     The invention provides a method for transmitting information across a communication channel, comprising the steps of:

- extracting, from a two-directional information flow signal at the side of a first subscriber, information transmitted by the first subscriber;
- modulating said extracted information with a carrier frequency $f_1$ for providing a frequency modulated (FM) information signal;
- mixing said frequency modulated (FM) information signal into said two-directional information flow signal in said communication channel;
- extracting at the side of a second subscriber from the two-directional information flow signal the transmitted frequency modulated (FM) information signal;
- demodulating said transmitted extracted frequency modulated (FM) information signal for providing the information as transmitted by the first subscriber;
- mixing the information into the two-directional information at the side of the second subscriber.

FIG. 1

EP 1 528 779 A1

**Description**

The present invention relates to a system and method for transmitting information over a communication channel. The invention relates more specifically to a system and method for transmitting information over a standard telephone communication channel.

Existing telephone modems using standard protocols such as V.34 or V.90 or V.92 provide the maximum information transmission rates only in high quality communication lines, where the ratio of the power of the signal to the power of the noise (S/N ratio) turns out to be more than 32 dB for the V.34 protocol and 52 dB for the V.90 and V.92 protocols. The norm for communication lines of a lesser quality, such as a telephone line, is a signal to noise (S/N) ratio of about 38-40 dB. In such lines the transmission rate stipulated by the V.34 protocol can still be obtained, but a transmission rate of 56 Kbit/s (protocols V.90 and V.92) is practically never reached. In noised communication lines, i. e. at S/N ratios up to 20-25 dB, which are widespread in the world, the transmission rate does not exceed 10-15 Kbit/s.

It is an object of the present invention to provide a system and method for transmitting data wherein at least the above drawbacks are obviated and which provide an increased transmission capacity over the communication channel.

A further object of the present invention is to provide a transmission system and transmission method with increased transmission capacity using standard telephone lines and existing systems (including modems, telephones, et cetera) and using standard communication protocols (V.34, V.90, V.92, for example).

According to a first aspect of the invention a method is provided for transmitting information across a communication channel, the method comprising the steps of:

- extracting at the side of a first subscriber communication information from a two-directional information signal from the first subscriber;
- modulating said communication information with carrier frequency $f_1$ for providing a frequency modulated information signal;
- directing said frequency modulated information signal into the two-directional communication channel;
- extracting at the side of a second subscriber from the two-directional communication channel the transmitted frequency modulated information signal;
- demodulating the extracted frequency modulated information signal for providing communication information;
- mixing the communication information into the two-directional information signal from the second subscriber.

According to a second aspect of the invention a system is provided for transmitting information through a communication channel, comprising:

- a first extractor, positioned at the side of a first subscriber, for extracting communication information from a two-directional information signal from the first subscriber;
- a modulator for modulating said communication information with carrier frequency $f_1$ for providing a frequency modulated information signal;
- a first mixer for directing said frequency modulated information signal into the two-directional communication channel;
- a second extractor, positioned at the side of a second subscriber, for extracting from the two-directional communication channel the transmitted frequency modulated information signal;
- a demodulator for extracting the frequency modulated information signal for providing communication information;
- a second mixer for mixing the communication information into the two-directional information signal from the second subscriber.

As mentioned above, the invention relates to the field of telephone communication and allows to increase the transmission capacity of a communication channel by a telephone line when using standard telephone apparatuses and modems by increasing the transmission capacity of a part of the communication channel in general and more specifically by increasing the part of the transmission capacity that is called the "last mile".

The method and system allows, under similar conditions, performing the transmission of information with higher (in comparison with prior channels) rate due to the fact that in the present method and system the transmission of information over a telephone communication line is carried out by applying a frequency modulation (FM) process, where as a modulating signal the information transmitted by a standard subscriber (telephone, modem), located in the respective end of a telephone line, is used. In the second end of a telephone line the transmitted FM signal is demodulated and sent to the second subscriber, in whose role as a rule ATS equipment acts, but such role can be also played by a telephone, a modem and so on. Similarly the transmission of information from the second subscriber to the first subscriber takes place.

In order to provide additional discrimination the carrier frequencies of frequency modulators are preferably chosen in such a way so that the bandwidths of FM signals from the first and second subscribers will not overlap.

Further features, properties and details of the present invention will be elucidated in the following description of several preferred embodiments of the present invention. In the description referral is made to figure 1 which shows a block diagram of an embodiment of the system according to the invention and to figure 2 which shows a diagram of a preferred embodiment of a part of the system, i.e. a preferred embodiment of a frequency modulator. Figure 3 shows a schematic diagram of one of the preferred arrangements of the first and second devices of the system according to the invention.

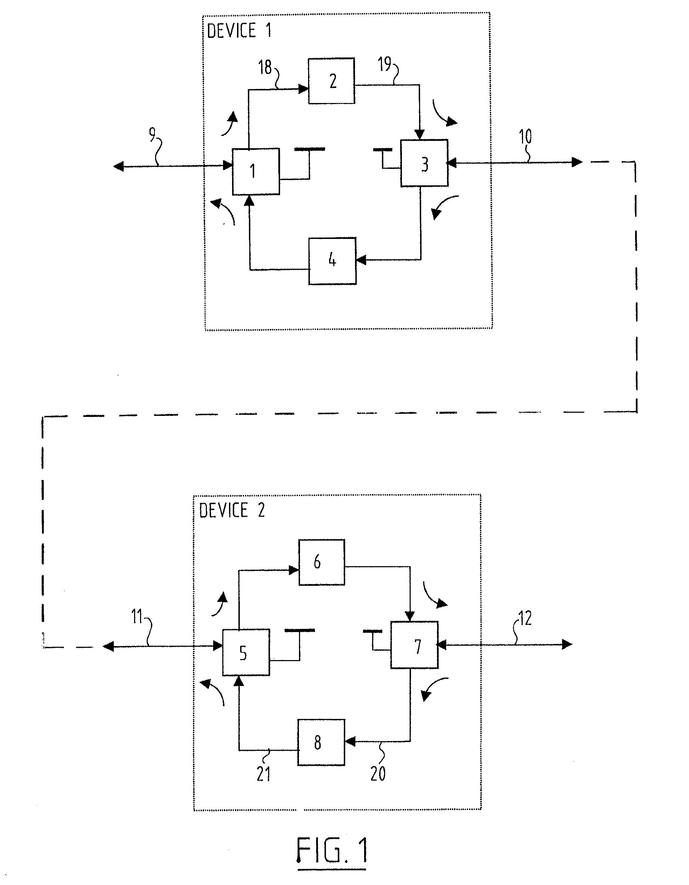

Fig. 1 shows the system implementing the method of the increase of the transmission capacity of a switched telephone communication channel by increasing the transmission capacity of a communication channel that is called the "last mile". The "last mile" is the part of the telephone communication channel between the subscriber (user) and the telephone station part of the telephone communication channel.

Usually the last mile is made in the form of twisted pair telephone wires. If the length of this part of communication exceeds 2 km and an information signal with a bandwidth of about 4 kHz is applied, it is, as a rule, hard, if not impossible, to provide in the last mile a signal to noise (S/N)-ratio of 52 dB, which is a minimum requirement for achieving a transmission rate of at least 56 kbit/s. The remaining parts of the telephone communication channel (backbone lines, equipment of the telephone stations and so on) may have a transmission capacity of 56 kBit/s. The task of increasing the overall data transmission capacity over a standard telephone communication channel may therefore be solved by sufficiently increasing the transmission capacity of the last mile.

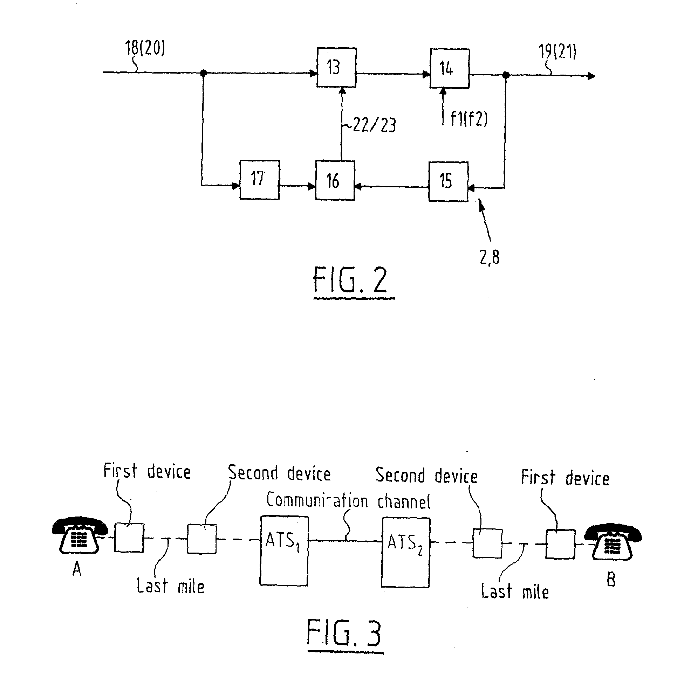

Figure 3 shows a typical arrangement of a telephone line and the system according to the invention. A first subscriber A is connected through a "last mile" section with a first switch ($ATS_1$), while the second subscriber B is connected through a "last mile" section with a second switch ($ATS_2$). Between both switches a further communication channel is present. According to the embodiment shown in figure 3 the system comprises two first devices 1 and two second devices 2, included into the breaks of the two-wire telephone lines. The first devices 1 are arranged on the side of subscriber A and on the side of subscriber B, while the second devices 2 are arranged at the position of the first ATS and at the position of the second ATS.

While figure 3 shows first and second devices according to the invention arranged at either end of the communication channel, in another preferred embodiment (not shown) the devices are arranged at one of the ends of the communication channel.

From the two-direction information flow from the side of the first subscriber with the help of differential transformer 1 information transmitted by the first subscriber is extracted. Frequency modulator 2 is modulated by this information with carrier frequency $f_1$. The received FM signal with the help of differential transformer 3 is directed (mixed) into a two-wire telephone line as a component of the two-directional FM flow 10. Having passed the telephone line the FM signal from the first subscriber with the help of differential transformer 5 is extracted from FM flow 11 and enters frequency demodulator 6, where information transmitted by the first subscriber is extracted with no (substantial) change of its structure (frequency bandwidth, type of modulation and so on). This information with the help of differential transformer 7 is mixed into the two-directional information flow 12, going to the information input/output of the second subscriber 2.

Similarly information transmitted by the second subscriber 20, with the help of differential transformer 7 enters frequency modulator 8, where it modulates carrier frequency $f_2$. FM signal from the output of frequency modulator 8 with the help of differential transformer 5 is directed to a telephone line as a component of two-directional FM flow 11 (the FM flow 11 being identical to FM flow 10 earlier mentioned). Having passed the telephone line FM signal from the second subscriber with the help of differential transformer 3 is extracted from FM flow 10 and enters frequency demodulator 4, where information transmitted by the second subscriber is extracted with no change of its structure. This information with the help of differential transformer 1 is mixed into the two-directional information flow 9, going to the information input/output of first subscriber 1.

In order to achieve the rate of 56 Kbit/s it is required that the S/N ratio at the output of frequency demodulator 4 (or 6, depending on the direction of transmission) is not less than 52 dB, as will be explained hereafter.

Information samples in the communication channel with a bandwidth of 4kHz can go with a clock frequency of 8 kHz. As a consequence, in order to achieve a rate of 56 kbit/s it is required to transmit 7-bit information samples with such clock frequency. The so-called Shannon formula shows for the threshold of the achievable transmission rate C for a signal in a continuous communication channel:

$$C = B * \log 2\ (P_s + P_n)\ /\ P_n,$$

where B is the transmission bandwidth of the communication channel, $P_s$ is the power of the signal, and $P_n$ is the power of the noise.

At a bandwidth of 4 kHz a rate of 56 kBit/s can be achieved if the expression $C=B*\log2\ (P_s+P_n)\ /P_n$ would be equal to 14. From this the ratio $(P_s+p_n)/P_n$ is equal to approximately 16000. And then the required signal to noise ratio S/N = 10*log10(16000) is approximately equal to 42 dB. In practice this limit is approximated by applying various coding methods. However, for the transmission of non-coded 7-bit information with a practically acceptable error probability a much larger signal to noise ratio (S/N) is required. For instance in order to provide an error probability not less than $10^{-5}$, a signal to noise ratio S/N of not less than 52 dB is required.

This requirement imposes rather rigid requirements on the level of non-linear distortions at the output of the corresponding frequency modulator (2 or 8), which is not to exceed 0.03 - 0.05 % (-66 - -70 dB). Such level of non-linear distortions is provided by the design of frequency modulators 2 and 8 in accordance with Fig.2.

Information 18 (20), transmitted by subscriber 1 (subscriber 2) arrives at the first input of subtracting unit 13, at whose second input error signal 22(23) is provided. The error signal 22(23) is formed by error signal former 16. The difference between information 18(20) and error signal 22(23) serves as modulating signal for voltage-controlled oscillator (VCO) 14. FM-signal 19(21) from the output of VCO 14 is transmitted to one of inputs of differential transformer 3(5) and at the same time - to the input of additional frequency demodulator 15, which preferably is identical to the respective main demodulator 6(4) of the given direction. The output signal of demodulator 15 is transmitted to one of the inputs of error signal former 16, to which second input information 18 (20) is transmitted by subscriber 1 (subscriber 2), and which has passed delay line 17. The delay line is needed to compensate signal delay at passing modulator 14 and demodulator 15. Error signal 22(23) at output of error signal former 16 is formed as difference between the output signal of demodulator 15 and the signal from the delay line 17.

Compensation of non-linear distortions at the output of the frequency modulator in the offered scheme turns out to be possible thanks to the fact that as frequency modulator 15 in this scheme a demodulator which is identical to the respective main demodulator of this direction is used 6(4)

If the S/N ratio at the output of frequency demodulator 4(6) amounts to 52 - 53 dB, the respective frequency modulator 2(8) built as indicated in Fig.2 will worsen this ratio for not more than 0.5 dB, which is quite acceptable from the point of view of the provision of data rate of 56 kBit/s.

The increase of a communication channel transmission capacity with the help of the offered method is based on the fact, that frequency modulation (FM) improves the S/N ratio at the output of the frequency demodulator not less than **$3m^2$** times, where

$$m = \omega_d/\Omega_{max}\text{- index of frequency modulation by the upper modulating frequency,}$$

$$\omega_d \text{ - deviation of frequency,}$$

$$\Omega_{max}\text{- upper modulating frequency.}$$

The gain in S/N ratio at the output of frequency demodulator will be observed at m more than 0.6. If we take m=5 for $\Omega_{max}/2\Pi$=3.5 kHz, the advantage in S/N ratio at the output of frequency demodulator will not be worse than 18 dB. As a consequence, the maximum protocol rate in the described system will be maintained up to the maintenance in a line in the bandwidth of a standard telephone signal of S/N ratio not worse than 14 dB for protocol V.34 and up to the maintenance in a line of S/N ratio not worse than 34 dB for protocols V.90 and V.92. At this frequency the bandwidth occupied by FM signal in a telephone line is approximately equal to 35 kHz. The increase of the modulation index m up to 10 increases the gain up to 25 dB at the widening of the bandwidth of FM signal up to 70 kHz. The increase of the modulation index has its limit due to the threshold effect of frequency demodulation, which starts to influence at the decrease of S/N for FM signal up to a certain critical value. The limit of **m** starts as earlier as the quality of a telephone line in a communication channel is worse. For instance, the increase of the modulation index up to 20 increases the gain up to 30 dB at the output of demodulator, but worsens S/N ratio in a line for FM signal in a line for 16 dB and thus does not permit the use of such modulation index in lines, where S/N ratio in the bandwidth of a telephone signal does not exceed 20-22 dB.

Thus the application of FM signal in telephone communication allows increasing significantly the real transmission capacity of a communication channel by telephone lines. At this it turns out to be possible to use all existing protocols without any changes.

The offered system is relatively simple in its implementation and cheap in the production.

Table I Dependence of data transmission rate C with error probability $10^{-6}$ on the ratio of the power of the signal to the power of noise $(P_s/P_n)$ in a telephone channel bandwidth for ordinary telephone lines

| $P_s/P_n$, dB | C, Kbit/s |
|---|---|
| 32 | 33.6 |
| 36 | 37 |
| 41 | 41 |
| 46 | 46 |
| 52 | 56 |

Table II Dependence of data transmission rate C with error probability $10^{-6}$ on the ratio of the power of the signal to the power of noise ($P_S/P_n$) in a telephone channel bandwidth for telephone lines with increased transmission capacity for frequency modulation index m=4

| $P_s/P_n$, dB | C, Kbit/s |
|---|---|
| 16 | 33.6 |
| 20 | 37 |
| 25 | 41 |
| 30 | 46 |
| 36 | 56 |

The present invention is not limited to the above described preferred embodiments thereof; the rights sought are defined by the following claims, within the scope of which many modifications can be envisaged.

**Claims**

1. Method for transmitting information across a communication channel, comprising the steps of:

    - extracting, from a two-directional information flow signal at the side of a first subscriber, information transmitted by the first subscriber;
    - modulating said extracted information with a carrier frequency $f_1$ for providing a frequency modulated (FM) information signal;
    - mixing said frequency modulated (FM) information signal into said two-directional information flow signal in said communication channel;
    - extracting at the side of a second subscriber from the two-directional information flow signal the transmitted frequency modulated (FM) information signal;
    - demodulating said transmitted extracted frequency modulated (FM) information signal for providing the information as transmitted by the first subscriber;
    - mixing the information into the two-directional information at the side of the second subscriber.

2. Method according to claim 1, further comprising:

    - extracting, from a two-directional information flow signal at the side of the second subscriber, information transmitted by the second subscriber;
    - modulating said extracted information with a second carrier frequency $f_2$ for providing a frequency modulated (FM) information signal;
    - mixing said frequency modulated (FM) information signal into said two-directional information flow signal in said communication channel;
    - extracting at the side of the first subscriber from the two-directional information flow signal the transmitted frequency modulated (FM) information signal;
    - demodulating said transmitted extracted frequency modulated (FM) information signal for providing the information as transmitted by the second subscriber;
    - mixing the information into the two-directional information at the side of the first subscriber.

3. Method according to claim 1 or 2, wherein the first carrier frequency $f_1$ and the second carrier frequency $f_2$ are chosen so as to avoid overlap of the bandwidths of the frequency modulated information signals from the first and the second subscriber.

4. Method according to claim 1, 2 or 3, comprising transmitting said information over a standard telephone line.

5. Method according to claim 4, comprising transmitting said information between a telephone and an automatic telephone system (ATS).

6. Method according to claim 4, comprising transmitting said information between a modem and an automatic telephone system (ATS).

7. System for transmitting information through a communication channel, comprising a first device including

   - a first extractor (1), positioned at the side of a first subscriber, for extracting information transmitted by the first subscriber from a two-directional information flow signal;
   - a modulator (2) for modulating said information (18) with a carrier frequency $f_1$ for providing a frequency modulated (FM) information signal;
   - a first mixer (3) for directing said frequency modulated (FM) information signal (19) into the two-directional information flow signal (10) existing in the communication channel from the side of the first subscriber; and a second device including
   - a second extractor (5), positioned at the side of a second subscriber, for extracting from the two-directional information flow signal (11), taken from the communication channel, the transmitted frequency modulated (FM) information signal (11);
   - a demodulator (6) for extracting from the frequency modulated (FM) information signal from the first subscriber the information transmitted by the first subscriber;
   - a second mixer (7) for mixing the information transmitted by the first subscriber into the two-directional information flow signal at the side of the second subscriber.

8. System according to claim 7, further comprising a third device including

   - a third extractor (7), positioned at the side of the second subscriber, for extracting further information, transmitted by the second subscriber (20) from said two-directional information flow signal from the second subscriber;
   - a second modulator (8) for modulating said further information (20) with a carrier frequency $f_2$ for providing a further frequency modulated (FM) information signal;
   - a third mixer (5) for directing said further frequency modulated information signal (21) into the two-directional information flow signal (10) existing in the communication channel; and a fourth device including
   - a fourth extractor (3), positioned at the side of the first subscriber, for extracting from the two-directional information flow signal, existing in the communication channel, the transmitted further frequency modulated (FM) information signal;
   - a second demodulator (4) for demodulating the frequency modulated (FM) information signal for providing the further information as transmitted by the second subscriber;
   - a fourth mixer (1) for mixing the further information, transmitted by the second subscriber, into the two-directional information flow signal at the side of the first subscriber (9).

9. System according to claims 7 and 8, wherein the first extractor (1) and the fourth mixer (1), the first mixer (3) and the fourth extractor (3), the third mixer (5) and the second extractor (5) and/or the third extractor (7) and second mixer (7) are combined.

10. System according to any of claims 7-9, wherein a mixer comprises a differential transformer.

11. System according to any of claims 7-10, wherein an extractor comprises a differential transformer.

12. System according to any of the claims 7-11, wherein a frequency modulator comprises:

   - a voltage-controlled oscillator (14),
   - an additional frequency demodulator (15);
   - an error signal former (16),
   - a subtracting unit (13);

wherein information transmitted by the first (second) subscriber 18(20) originating from extractor 1(7) is supplied to the first input of subtracting unit (13), to whose second input an error signal 22(23) is supplied, the error signal being formed by error signal former (16) and

wherein the difference between transmitted information 18(20) and error signal 22(23) serves as modulating signal for voltage-controlled oscillator 14, wherein the output of the voltage-controlled oscillator 19(21) is transmitted to one of the inputs of mixer 3(5) and to the input of additional frequency demodulator 15, the output of demodulator 15 being transmitted to one of the inputs of error signal former 16, to which second input information 18 (20) is transmitted.

**13.** System according to claim 12, in which demodulator 15 is identical to demodulator 6(4).

**14.** System according to claim 12 or 13, wherein a delay line is provided for compensation of the delay at passing modulator 14 and demodulator 15.

**15.** System according to any of claims 7-14, wherein the communication channel is a standard telephone line.

**16.** System according to any of the preceding claims, wherein the first and fourth devices are connected in series to the first subscriber end of the telephone line, while the second and third devices are connected in series to the second subscriber end of the telephone line.

**17.** System according to claim 16, wherein the telephone line is the "last mile" portion of a telephone communication channel.

**18.** System according to any of the preceding claims 7-17, wherein the first and/or second subscriber is a telephone or a modem.

**19.** System according to any of the preceding claims 7-17, wherein the second subscriber is an automatic telephone system (ATS).

**20.** Method according to any of the preceding claims, comprising transmitting the information with a transmission rate of at least 56 Kbit/s in case of a signal-to-noise-ratio S/N of at least 36 dB, with a transmission rate of at least 46 Kbit/s in case of a signal-to-noise-ratio S/N of at least 30 dB, with a transmission rate of at least 41 Kbit/s in case of a signal-to-noise-ratio S/N of at least 25 dB, with a transmission rate of at least 37 Kbit/s in case of a signal-to-noise-ratio S/N of at least 20 dB, and/or with a transmission rate of at least 33 Kbit/s in case of a signal-to-noise-ratio S/N of at least 16 dB.

FIG.1

18(20)                    13          14              19(21)

~22/23      f1(f2)

17    16    15

2,8

# FIG. 2

First device    Second device    Second device    First device
           Communication channel

ATS₁                ATS₂

A    Last mile                          Last mile    B

# FIG. 3

**European Patent Office**

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2001/019582 A1 (OKITA RYOJI ET AL) 6 September 2001 (2001-09-06) | 1-11, 13-20 | H04M11/06 H03F1/32 H03C3/09 H04L27/12 H04B1/04 |
| Y | * abstract * * paragraph [0003] * * paragraphs [0050],[0051] * --- | 12 | |
| Y | EP 1 217 754 A (NOKIA CORP) 26 June 2002 (2002-06-26) * column 1, line 48 - column 9, line 4 * --- | 12 | |
| A | US 6 282 246 B1 (OKITA RYOJI ET AL) 28 August 2001 (2001-08-28) * the whole document * --- | 1-20 | |
| A | US 6 566 948 B1 (BRAITHWAITE RICHARD NEIL) 20 May 2003 (2003-05-20) * the whole document * ----- | 1-20 | |

TECHNICAL FIELDS SEARCHED (Int.Cl.7)

H04M
H03F
H03C
H04L
H04B

The present search report has been drawn up for all claims

| Place of search | Date of completion of the search | Examiner |
|---|---|---|
| MUNICH | 1 March 2004 | Tillgren, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 03 07 8399

This annex lists the patent family members relating to the patent documents cited in  the above-mentioned European search report.
The members are as contained in the European Patent Office EDP file on
The European Patent Office is in no way liable for these particulars which are merely  given for the purpose of information.

01-03-2004

| Patent document cited in search report | | Publication date | Patent family member(s) | | Publication date |
|---|---|---|---|---|---|
| US 2001019582 | A1 | 06-09-2001 | JP<br>JP<br>GB<br>GB<br>US | 3373385 B2<br>10257107 A<br>2365732 A ,B<br>2323257 A ,B<br>6282246 B1 | 04-02-2003<br>25-09-1998<br>20-02-2002<br>16-09-1998<br>28-08-2001 |
| EP 1217754 | A | 26-06-2002 | EP<br>GB<br>US | 1217754 A1<br>2374742 A<br>2002093378 A1 | 26-06-2002<br>23-10-2002<br>18-07-2002 |
| US 6282246 | B1 | 28-08-2001 | JP<br>JP<br>GB<br>GB<br>US | 3373385 B2<br>10257107 A<br>2365732 A ,B<br>2323257 A ,B<br>2001019582 A1 | 04-02-2003<br>25-09-1998<br>20-02-2002<br>16-09-1998<br>06-09-2001 |
| US 6566948 | B1 | 20-05-2003 | EP<br>JP | 1345319 A2<br>2003273753 A | 17-09-2003<br>26-09-2003 |

EPO FORM P0459

For more details about this annex : see Official Journal of the European Patent Office, No. 12/82